# DEMANDE DE BREVET EUROPEEN

(11) **EP 4 120 332 A1**
(43) Date de publication de la demande: **18.01.2023**
(21) Numéro de dépôt: 22182982.3
(22) Date de dépôt: 05.07.2022
(51) Int. Cl.: H01L 21/78

(54) **PROCÉDÉ DE FABRICATION DE PUCES ÉLECTRONIQUES**

(30) Priorité: 16.07.2021 FR 2107694
(71) Demandeur: STMicroelectronics (Tours) SAS, 37100 Tours (FR)
(72) Inventeur: ORY, Olivier, 37100 TOURS (FR); RABIER, Philippe, 37300 Joué-lés-Tours (FR)
(74) Mandataire: Cabinet Beaumont

(57) **Abrégé**

La présente description concerne un procédé de fabrication de puces électroniques comprenant :
a) le dépôt d'une couche de résine (19) électriquement isolante du côté d'une première face d'un substrat semiconducteur (11), dans et sur lequel ont été préalablement formés une pluralité de circuits intégrés (13), le substrat semiconducteur portant sur une deuxième face, opposée à la première face, des plots de reprise de contact (17) ; et
b) la formation, du côté de la deuxième face du substrat semiconducteur (11), de premières tranchées (21), séparant électriquement les circuits intégrés (13) les uns des autres, les premières tranchées s'étendant verticalement dans le substrat semiconducteur et débouchant dans ou sur la couche de résine (19).

## Description

### Domaine technique

La présente description concerne de façon générale la fabrication de puces électroniques semiconductrices.

### Technique antérieure

De façon classique, un procédé de fabrication de puces électroniques peut comprendre une étape de test électrique final, au cours de laquelle on vient appliquer des signaux électriques de test sur des métallisations de connexion des puces, au moyen de pointes métalliques de test connectées électriquement à un dispositif électronique de test.

Il serait souhaitable d'améliorer au moins en partie certains aspects des procédés connus de fabrication de puces électroniques.

### Résumé de l'invention

Pour cela, un mode de réalisation prévoit un procédé de fabrication de puces électroniques comprenant :
une étape a) de dépôt d'une couche de résine électriquement isolante du côté d'une première face d'un substrat semiconducteur, dans et sur lequel ont été préalablement formés une pluralité de circuits intégrés, le substrat semiconducteur portant sur une deuxième face, opposée à la première face, des plots de reprise de contact ; et
une étape b) de formation, du côté de la deuxième face du substrat semiconducteur, de premières tranchées, séparant électriquement les circuits intégrés les uns des autres, les premières tranchées s'étendant verticalement dans le substrat semiconducteur et débouchant dans ou sur la couche de résine.

Selon un mode de réalisation, l'étape b) est suivie par une étape c) d'individualisation des puces électroniques.

Selon un mode de réalisation, l'individualisation de l'étape c) est réalisée par la formation de deuxièmes tranchées dans les premières tranchées.

Selon un mode de réalisation, l'individualisation de l'étape c) est réalisée par l'amincissement de la couche de résine isolante.

Selon un mode de réalisation, le procédé comprend, entre les étapes b) et c), une étape d) de test électrique des circuits intégrés.

Selon un mode de réalisation, les premières tranchées s'étendent dans toute l'épaisseur du substrat.

Selon un mode de réalisation, le procédé comprend, entre l'étape a) et l'étape b), une étape de formation de troisièmes tranchées s'étendant, entre les circuits intégrés, de la première face du substrat semiconducteur sur une partie de l'épaisseur du substrat semiconducteur.

Selon un mode de réalisation, les troisièmes tranchées s'étendent dans le substrat semiconducteur sur une profondeur comprise entre 30 % et 75 % de l'épaisseur du substrat semiconducteur.

Selon un mode de réalisation, les troisièmes tranchées ont une largeur supérieure à la largeur des premières tranchées.

Selon un mode de réalisation, lors de l'étape a), l'épaisseur du substrat semiconducteur est comprise entre 50 µm et 500 µm, de préférence entre 50 µm et 130 µm.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre, par une vue en coupe, une étape d'un exemple de procédé de fabrication d'une puce électronique selon un premier mode de réalisation ;
la figure 2 illustre, par une vue en coupe, une autre étape d'un exemple de procédé de fabrication d'une puce électronique selon un premier mode de réalisation ;
la figure 3 illustre, par une vue en coupe, une autre étape d'un exemple de procédé de fabrication d'une puce électronique selon un premier mode de réalisation ;
la figure 4 illustre, par une vue en coupe, une autre étape d'un exemple de procédé de fabrication d'une puce électronique selon un premier mode de réalisation ;
la figure 5 illustre, par une vue en coupe, une autre étape d'un exemple de procédé de fabrication d'une puce électronique selon un premier mode de réalisation ;
la figure 6 illustre, par une vue en coupe, une autre étape d'un exemple de procédé de fabrication d'une puce électronique selon un premier mode de réalisation ;
la figure 7 illustre, par une vue en coupe, une étape d'un exemple de procédé de fabrication d'une puce électronique selon un deuxième mode de réalisation ;
la figure 8 illustre, par une vue en coupe, une autre étape d'un exemple de procédé de fabrication d'une puce électronique selon un deuxième mode de réalisation ;
la figure 9 illustre, par une vue en coupe, une autre étape d'un exemple de procédé de fabrication d'une puce électronique selon un deuxième mode de réalisation ;
la figure 10 illustre, par une vue en coupe, une autre étape d'un exemple de procédé de fabrication d'une puce électronique selon un deuxième mode de réalisation ;
la figure 11 illustre, par une vue en coupe, une autre étape d'un exemple de procédé de fabrication d'une puce électronique selon un deuxième mode de réalisation ; et
la figure 12 illustre, par une vue en coupe, une autre étape d'un exemple de procédé de fabrication d'une puce électronique selon un deuxième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des circuits intégrés présents dans les puces électroniques décrites n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des vues en coupe des figures correspondantes.

Sauf précision contraire, les expressions "environ", "approximativement", "sensiblement", et "de l'ordre de" signifient à 10 % près, de préférence à 5 % près.

De façon classique, un procédé de fabrication de puces électroniques comprend la réalisation simultanée d'une pluralité de puces électroniques, par exemple identiques ou similaires, dans et sur un même substrat semiconducteur. En fin de procédé, une étape de découpe ("dicing" en anglais) est mise en oeuvre pour individualiser les puces.

Avant l'étape de découpe, un film adhésif de support est fixé du côté d'une des faces du substrat, de façon que, à l'issue de l'étape de découpe, une fois individualisées, les puces restent soutenues par le film de support.

Une étape de test électrique final peut être mise en oeuvre avant l'étape de découpe des puces individuelles. Ceci permet de tester plusieurs puces simultanément tout en garantissant la stabilité mécanique des puces lors de l'application des pointes de test. Toutefois des couplages électriques parasites, via le substrat, peuvent alors exister entre les différentes puces, ce qui peut fausser les résultats des tests.

Alternativement, l'étape de test peut être mise en oeuvre après l'étape de découpe des puces individuelles. Ceci permet d'assurer l'isolation électrique des puces les unes par rapport aux autres lors du test. Toutefois, la stabilité mécanique des puces n'est alors plus assurée. Ceci peut poser problème notamment pour des puces de petites dimensions, dont la stabilité mécanique est alors trop faible pour permettre l'application des pointes de test.

On notera qu'on s'intéresse ici plus particulièrement à des procédés de fabrication de puces électroniques dans lesquels au moins une partie des flancs du substrat de la puce est laissée libre, non revêtue par une résine de protection, à l'issue de l'étape de découpe. En effet, des procédés de fabrication existent dans lesquels, à l'issue de l'étape de découpe, les flancs du substrat de la puce sont entièrement recouverts par une résine de protection. De tels procédés sont toutefois plus onéreux.

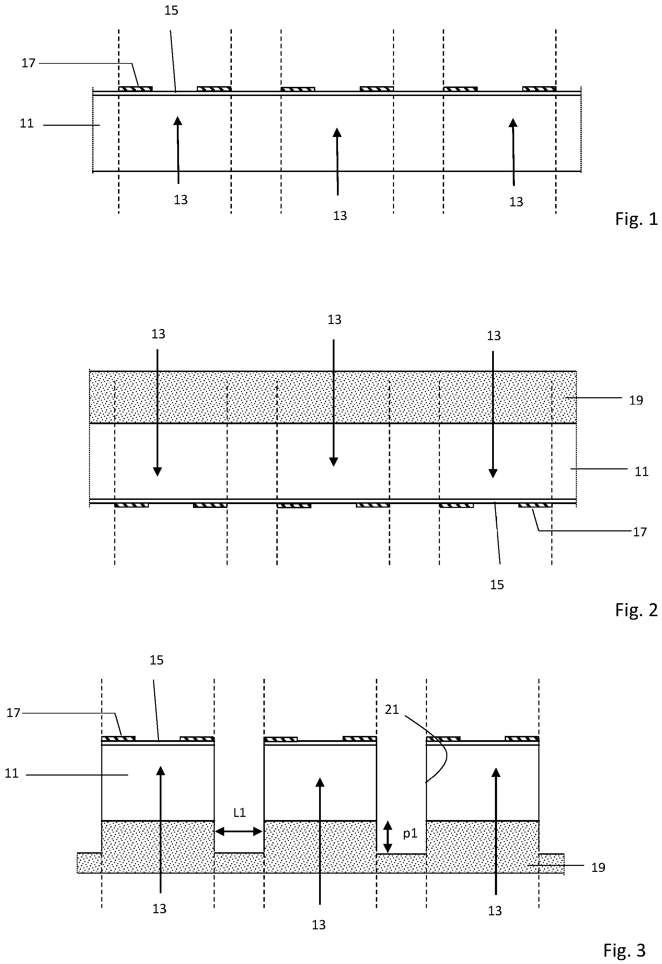

Les figures 1 à 6 sont des vues en coupe illustrant des étapes successives d'un exemple d'un procédé de fabrication de puces électroniques selon un premier mode de réalisation.

La figure 1 correspond à une structure comprenant un substrat semiconducteur 11 dans et sur lequel des circuits intégrés 13 ont été préalablement formés. Les circuits 13 sont par exemple tous identiques aux dispersions de fabrication près.

Le substrat 11 peut correspondre à une plaquette d'un matériau semiconducteur, par exemple du silicium dont l'épaisseur a été réduite afin d'obtenir une épaisseur correspondant à l'épaisseur finale souhaitée du substrat 11 dans la puce électronique. Le substrat 11 a, par exemple, une épaisseur comprise entre 50 µm et 500 µm, par exemple comprise entre 50 µm et 130 µm.

La structure de la figure 1 comprend en outre un empilement de couches isolantes et conductrices également appelé empilement d'interconnexion 15 revêtant la face supérieure du substrat 11. L'empilement d'interconnexion 15 comprend en outre, du côté de sa face supérieure, pour chaque circuit intégré 13, un ou plusieurs plots de reprise de contact 17. Les plots de reprise de contact 17 peuvent comprendre un empilement d'une ou plusieurs couches métalliques. Les plots de reprise de contact 17 sont par exemple des métallisations sous bossage (UBM, de l'anglais "Under Bump Metallization").

Chaque circuit intégré 13 comprend, par exemple, un ou plusieurs composants électroniques (transistors, diodes, thyristors, triacs, etc.).

En figure 1, trois circuits intégrés 13 ont été représentés, étant entendu que le nombre de circuits intégrés 13 formés dans et sur le substrat 11 peut être différent de trois. En pratique, le substrat 11 est une plaquette en un matériau semiconducteur, par exemple, du silicium, et plusieurs dizaines voire plusieurs centaines ou milliers de circuits intégrés 13 sont formés dans et sur le substrat 11. Les circuits intégrés 13 sont alors, par exemple, organisés en réseau en lignes et en colonnes en suivant un quadrillage régulier.

Dans la suite de cette description, on considère, dans l'orientation de la figure 1, la face inférieure de la structure ou du substrat comme étant la face arrière et la face supérieure de la structure ou du substrat comme étant la face avant.

La figure 2 illustre, par une vue en coupe, une étape de dépôt d'une couche de résine de protection 19 électriquement isolante en face arrière de la structure illustrée en figure 1 (c'est-à-dire la face inférieure dans l'orientation de la figure 1).

On notera que dans l'exemple de la figure 2, l'orientation de la structure est inversée par rapport à la vue en coupe de la figure 1.

Lors de cette étape, on vient recouvrir intégralement (pleine plaque) la face arrière de la structure par la résine 19. La résine 19 est, par exemple, une résine époxy, du parylène, ou un autre polymère électriquement isolant. Dans cet exemple, la résine 19 est déposée sur et en contact avec la face arrière du substrat semiconducteur 11. La résine présente par exemple une épaisseur sensiblement uniforme sur toute la surface arrière du substrat 11. A titre d'exemple, la résine 19 est initialement déposée sous forme liquide ou visqueuse, puis durcie, par exemple par recuit.

La résine 19 présente de préférence une épaisseur relativement importante de façon à rigidifier la structure, afin qu'elle puisse subir des étapes ultérieures, notamment de découpe, avec un risque de casse limité. A titre d'exemple, la couche de résine 19 présente une épaisseur supérieure à 70 µm.

La figure 3 illustre, par une vue en coupe, une étape de formation de tranchées de découpe 21 à partir de la face avant de la structure illustrée en figure 2 (c'est-à-dire la face inférieure dans l'orientation de la figure 2).

On notera que dans l'exemple de la figure 3, l'orientation de la structure est inversée par rapport à la vue en coupe de la figure 2.

Les tranchées 21 s'étendent entre les circuits 13 de sorte que chaque circuit 13 soit séparé latéralement de ses voisins par des tranchées 21. A titre d'exemple, chaque circuit 13 est entièrement délimité ou entouré, latéralement, par des tranchées 21. Les tranchées 21 peuvent, par exemple, en vue de dessus, former une grille continue s'étendant entre les circuits intégrés 13.

Dans l'exemple représenté, les tranchées 21 s'étendent verticalement, depuis la face avant de la structure (c'est-à-dire la face supérieure dans l'orientation de la figure 3), plus précisément depuis la face supérieure de l'empilement 15. Les tranchées 21 traversent toute l'épaisseur de l'empilement 15 et du substrat 11, et une partie de l'épaisseur de la résine 19. Les tranchées 21 s'interrompent dans la couche de résine 19, sans la traverser entièrement.

Ainsi, à l'issue de l'étape de formation des tranchées 21, chaque circuit intégré 13 est isolé électriquement mais solidaire mécaniquement des circuits intégrés 13 voisins.

Les tranchées 21 sont, par exemple, réalisées par découpe plasma, par sciage à l'aide d'une lame ou par découpe laser.

Les tranchées 21 ont une largeur L1, par exemple comprise entre 20 µm et 150 µm, par exemple de l'ordre de 50 µm. Les tranchées 21 s'étendent dans la résine 19 sur une profondeur p1, par exemple, supérieure à 20 µm. De préférence, l'épaisseur de résine 19 subsistant au fond des tranchées 21 est d'au moins 50 µm.

A titre de variante, non représentée, les tranchées 21 peuvent s'interrompre sur la face supérieure de la couche de résine 19. Dans ce cas, la profondeur p1 est nulle. Ceci peut par exemple être le cas avec une découpe plasma, sélective par rapport à la résine 19.

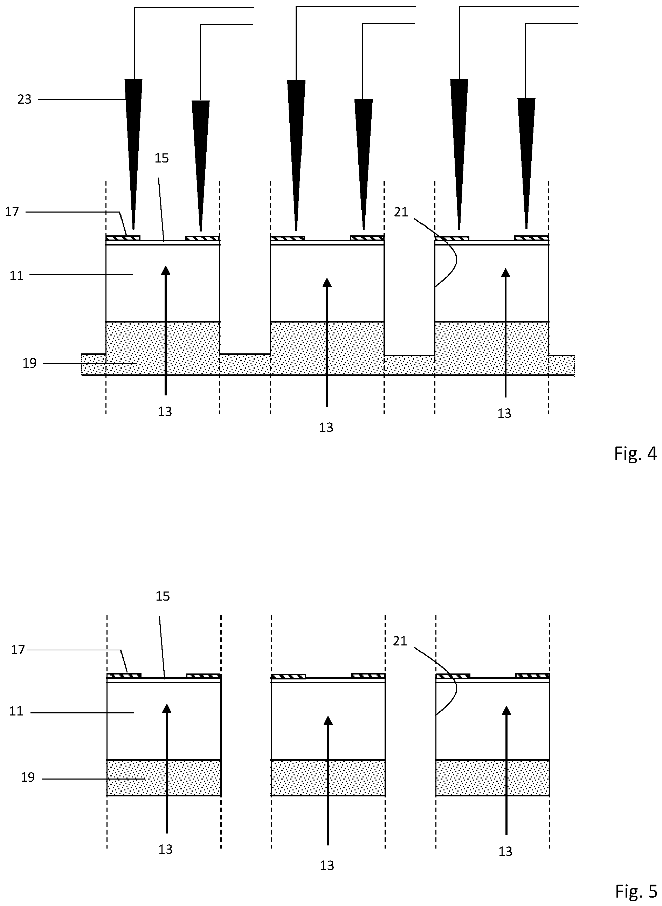

La figure 4 illustre, par une vue en coupe, une étape de test électrique des circuits intégrés 13.

Le test électrique consiste dans cet exemple à appliquer des signaux électriques de test sur les métallisations de connexion 17 des puces, au moyen de pointes métalliques de test 23 connectées électriquement à un dispositif de test (non représenté). A titre d'exemple, à cette étape, plusieurs puces sont testées électriquement en parallèle.

Lors de cette étape, les circuits intégrés 13 formés sur une même plaquette de substrat semiconducteur 11 sont, par exemple, tous testés. A titre d'exemple, les circuits intégrés 13 sont testés simultanément par groupes de plusieurs circuits 13. Autrement dit, les circuits 13 sont répartis en plusieurs groupes de plusieurs circuits 13 chacun, les circuits 13 d'un même groupe étant testés simultanément et les circuits 13 de groupes distincts étant testés séquentiellement. A titre d'exemple, les circuits intégrés 13 sont testés simultanément par groupes de huit par huit, seize par seize, soixante quatre par soixante quatre, voire par groupes de plus grandes dimensions.

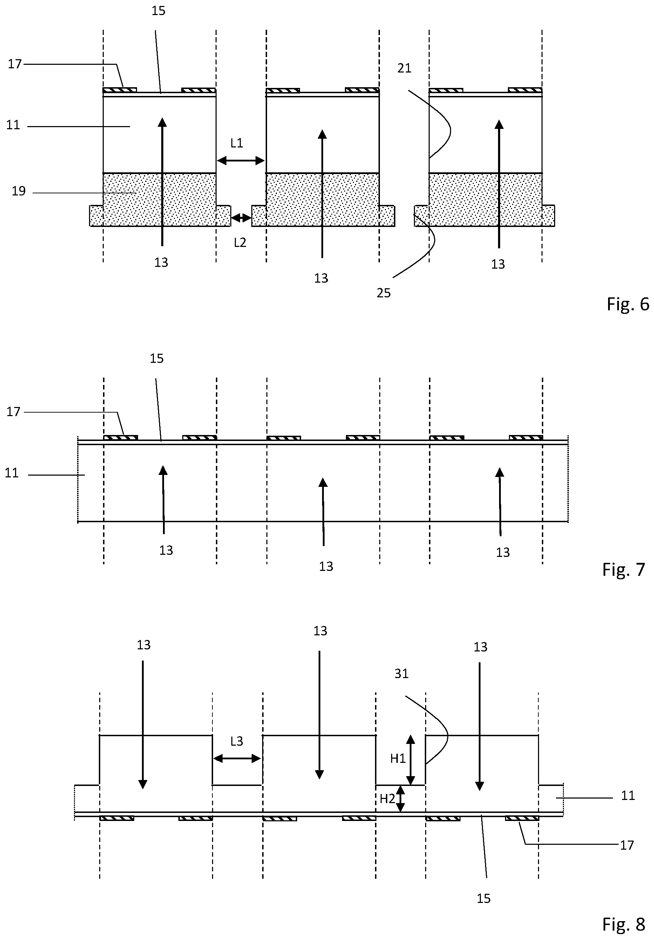

Les figures 5 et 6 illustrent deux exemples de mise en oeuvre d'une étape de découpe de la structure illustrée en figure 4 en puces individuelles comprenant chacune un unique circuit intégré 13.

Dans l'exemple de la figure 5, l'individualisation des puces est obtenue en amincissant la couche de résine 19 par la face arrière.

Préalablement à cette étape, un film support adhésif, par exemple un film souple, non représenté en figure 5, est fixé du côté de la face avant de la structure.

On vient ensuite retirer une partie de l'épaisseur de la résine 19 par sa face arrière. L'amincissement est par exemple réalisé par polissage mécanique ou par polissage mécano-chimique (CMP, de l'anglais "Chemical Mechanical Polishing").

Dans l'exemple représenté, l'amincissement est interrompu lorsque le fond des tranchées 21 est atteint et lorsque l'épaisseur finale souhaitée de la couche de résine 19 est atteinte. A titre d'exemple, l'épaisseur de résine 19 subsistant en face arrière des puces à l'issue de l'étape d'amincissement est inférieure à 100 µm, par exemple inférieure à 30 µm.

A l'issue de l'étape illustrée en figure 5, la structure correspond à une pluralité de puces électroniques individuelles, reliées uniquement par le film support (non représenté en figure 5). Chacune des puces individuelles comprend un unique circuit intégré 13. Les puces peuvent ensuite être prélevées, par leur face arrière, sur le film support, en vue de leur montage dans un dispositif extérieur.

En variante, la structure illustrée en figure 5 est rapportée par sa face arrière sur un autre film support, par exemple un film souple, puis le film support situé sur la face avant de la structure est retiré. Les puces peuvent ensuite être prélevées, par leur face avant, sur cet autre film support, en vue de leur montage dans un dispositif extérieur.

Dans l'exemple de la figure 6, l'individualisation des puces est obtenue par la formation de tranchées 25 traversantes à partir de la face avant de la structure.

Préalablement à cette étape, la structure est rapportée, par sa face arrière (face inférieure dans l'orientation de la figure 6), sur un film support, par exemple un film souple, non représenté en figure 6.

Afin de découper la structure en puces individuelles comprenant chacune un unique circuit intégré 13, les tranchées 25 sont réalisées en vis-à-vis des tranchées 21 dans la résine 19. Plus particulièrement, on vient former dans chaque tranchée 21 une tranchée 25 parallèle à ladite tranchée 21. Dans cet exemple, les tranchées 25 s'étendent sur toute la longueur des tranchées 21. Les tranchées 25 s'étendent, verticalement, à travers la résine 19, à partir du fond des tranchées 21, et débouchent du côté de la face arrière de la couche de résine 19. Ainsi, la résine 19 est coupée en vis-à-vis des tranchées 21. Les tranchées 25 ont une largeur L2 inférieure ou égale à la largeur L1.

Les tranchées 25 peuvent, par exemple, être réalisées par sciage, en utilisant une lame de découpe de largeur inférieure à celle utilisée pour la réalisation des tranchées 21. Les tranchées 25 peuvent en variante être réalisées par ablation laser ou par toute autre technique de découpe. Les tranchées 21 et les tranchées 25 sont par exemple alignées selon un même axe central.

A l'issue de l'étape illustrée en figure 6, la structure correspond à une pluralité de puces électroniques individuelles, reliées uniquement par le film support (non représenté en figure 6), chacune des puces individuelles comprenant un unique circuit intégré 13. Les puces peuvent ensuite être prélevées sur ce film support, en vue de leur montage dans un dispositif extérieur.

A l'issue du procédé décrit en relation avec les figures 1 à 6, on obtient des puces élémentaires dans lesquelles uniquement la face arrière du substrat 11 est revêtue par une couche de résine de protection 19. En particulier, les flancs du substrat 11 restent libres, c'est-à-dire non revêtus par une résine de protection électriquement isolante.

Un avantage du procédé décrit ci-dessus est qu'il permet d'obtenir une structure intermédiaire dans laquelle les circuits intégrés 13 sont isolés électriquement mais solidaires mécaniquement des circuits intégrés 13 voisins (figure 3). Le test électrique final des puces peut avantageusement être réalisé sur cette structure intermédiaire, avant l'étape d'individualisation des puces.

Les figures 7 à 12 sont des vues en coupe illustrant des étapes successives d'un exemple d'un procédé de fabrication de puces électroniques selon un deuxième mode de réalisation.

La figure 7 correspond à une structure identique ou similaire à la structure illustrée en figure 1 et ne sera pas détaillée à nouveau ci-après.

La figure 8 illustre, par une vue en coupe, une étape de formation de tranchées de découpe 31 à partir de la face arrière de la structure illustrée en figure 7.

On notera que dans l'exemple de la figure 8, l'orientation de la structure est inversée par rapport à la vue en coupe de la figure 7.

Dans l'exemple représenté, les tranchées 31 s'étendent verticalement depuis la face arrière du substrat 11 et se prolongent dans le substrat 11. Dans cet exemple, les tranchées 31 sont non traversantes, c'est-à-dire qu'elles ne débouchent pas du côté de la face avant du substrat 11.

Dans l'exemple représenté, les tranchées 31 s'étendent entre les circuits 13 de sorte que, en vue de dessus, chaque circuit 13 soit séparé des circuits 13 voisins par des tranchées 31. Les tranchées 31 peuvent, par exemple, en vue de dessus, former une grille continue s'étendant entre les circuits intégrés 13.

Les tranchées 31 s'étendent verticalement sur une profondeur H1. La profondeur H1 peut être comprise entre 30 % et 75% de l'épaisseur du substrat 11. A titre d'exemple, la profondeur H1 est choisie de sorte qu'une épaisseur H2 de substrat 11 comprise entre 20 µm et 50 µm subsiste entre le fond des tranchées 31 et la face avant du substrat 11. Les tranchées 31 ont par exemple une largeur L3 comprise entre 20 µm et 120 µm, de préférence comprise entre 40 µm et 70 µm, par exemple égale à environ 50 µm.

Les tranchées 31 sont, par exemple, réalisées par découpe plasma. A titre de variante, les tranchées 31 sont réalisées par sciage à l'aide d'une lame.

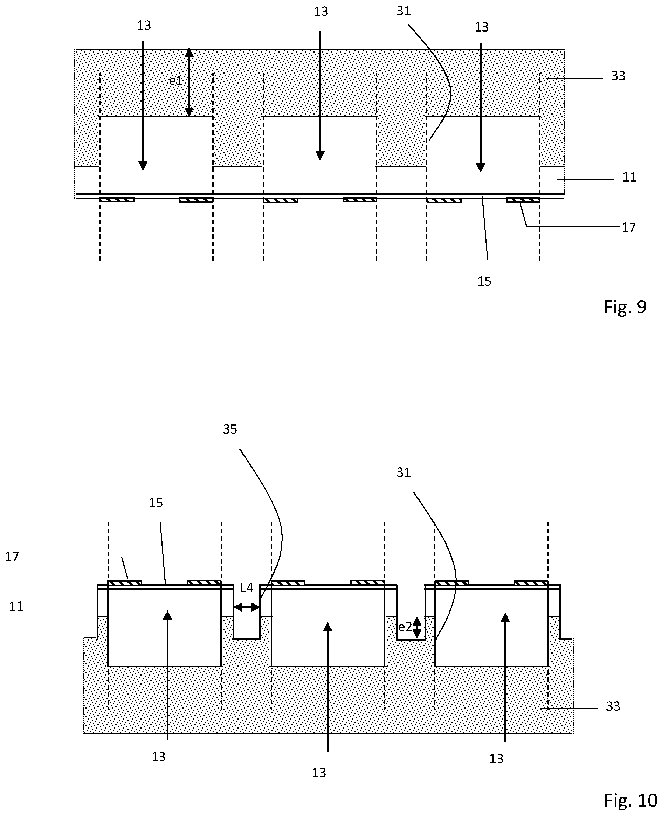

La figure 9 illustre, par une vue en coupe, une étape de dépôt d'une résine de protection 33 en face arrière de la structure illustrée en figure 8.

Lors de cette étape, on vient recouvrir intégralement (pleine plaque) la face arrière de la structure (c'est à dire la face supérieure dans l'orientation des figures 8 et 9) par la résine 33, et en particulier combler les tranchées 31 et recouvrir la face arrière du substrat 11. La résine 33 est, par exemple, identique ou similaire à la résine 19 décrite en relation avec les figures 1 à 6.

A titre d'exemple, la résine 33 est déposée de sorte qu'elle forme une couche d'une épaisseur e1 non nulle, par exemple une épaisseur e1 de l'ordre de 20 µm, sur la face arrière du substrat 11, hors des tranchées 31.

La figure 10 illustre, par une vue en coupe, une étape de formation de tranchées de découpe 35 à partir de la face avant de la structure illustrée en figure 9.

On notera que dans l'exemple de la figure 10, l'orientation de la structure est inversée par rapport à la vue en coupe des figures 8 et 9.

Lors de cette étape, les tranchées 35 sont formées dans le substrat 11 et dans la résine 33 située à l'intérieur des tranchées 31. Des tranchées 35 sont réalisées dans toutes les tranchées 31 et sur toute leur longueur. Les tranchées 35 s'étendent verticalement à travers le substrat 11 et une partie de l'épaisseur de la résine 33. A titre d'exemple, les tranchées 35 s'étendent dans la résine 33 sur une profondeur e2 comprise entre 10 µm et 40 µm.

Les tranchées 35 ont une largeur L4. La largeur L4 est inférieure à la largeur L3 de sorte qu'une partie de chacun des flancs latéraux du substrat 11 de chaque puce, délimitée par les tranchées 35, reste recouverte par la résine 33, par exemple sur une épaisseur comprise entre 5 µm et 10 µm. Les tranchées 35 peuvent, par exemple, être réalisées par sciage, en utilisant une lame de découpe de largeur inférieure à celle utilisée pour la réalisation des tranchées 31. Les tranchées 35 peuvent, en variante, être réalisées par ablation laser ou par toute autre technique de découpe, par exemple par gravure plasma. Les tranchées 31 et les tranchées 35 sont par exemple alignées selon un même axe central. La largeur L4 est, par exemple, comprise entre 5 µm et 20 µm.

A titre de variante, non représentée, les tranchées 35 s'interrompent sur la face supérieure de la résine 33 (épaisseur e2 nulle). Ceci peut par exemple être le cas lorsque les tranchées 35 sont réalisées au moyen d'une découpe plasma, sélective par rapport à la résine 33.

A l'issue de l'étape de formation des tranchées 35 illustrée en figure 10, chaque circuit intégré 13 est isolé électriquement mais solidaire mécaniquement des circuits intégrés 13 voisins.

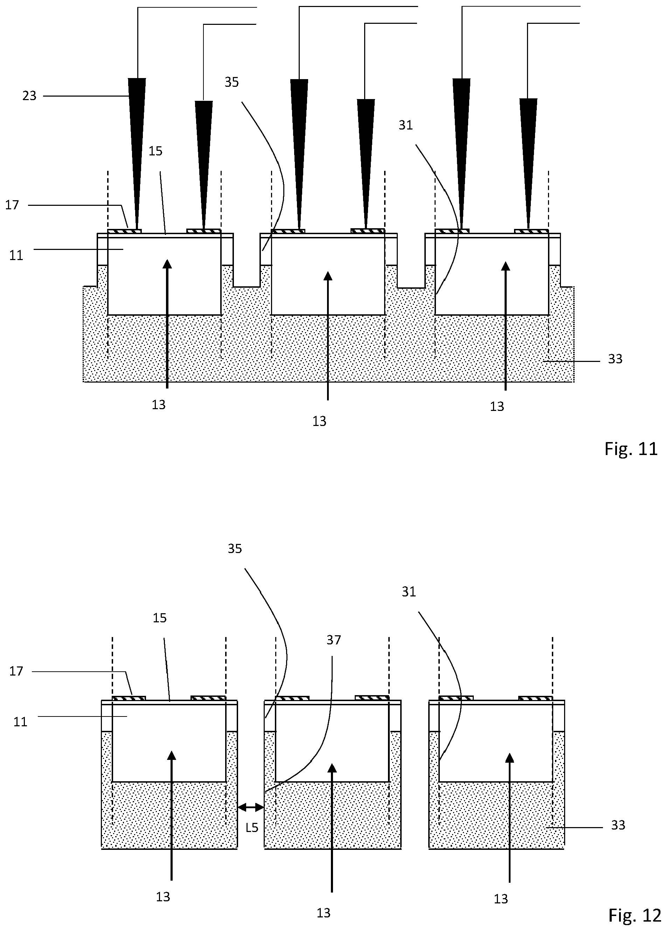

La figure 11 illustre, par une vue en coupe, une étape de test électrique des circuits intégrés 13, identique ou similaire à l'étape de test illustrée en figure 4.

La figure 12 illustre, par une vue en coupe, une étape de découpe de la structure illustrée en figure 11 en puces individuelles comprenant chacune un unique circuit intégré 13.

Lors de cette étape, on vient réaliser des tranchées 37 traversantes à partir de la face avant de la structure illustrée en figure 10 ou 11 (c'est-à-dire la face supérieure dans l'orientation des figures 10 et 11).

Préalablement à cette étape, la structure est rapportée, par sa face arrière (face inférieure dans l'orientation de la figure 12), sur un film support, par exemple un film souple, non représenté en figure 12.

Afin de découper la structure en puces individuelles, les tranchées 37 sont réalisées en vis-à-vis des tranchées 35 dans la résine 33. Plus particulièrement, on vient former en vis-à-vis de chaque tranchée 35 une tranchée 37 parallèle à ladite tranchée 35. Dans cet exemple, les tranchées 37 s'étendent sur toute la longueur des tranchées 35. Les tranchées 37 s'étendent, verticalement, de sorte que la résine 33 présente dans les tranchées 31 soit coupée en vis-à-vis des tranchées 35. Les tranchées 37 ont une largeur L5 inférieure ou égale à la largeur L3 des tranchées 31. De préférence, la largeur des tranchées L5 est supérieure ou égale à la largeur L4 des tranchées 31 de façon à éviter la formation d'une marche dans la résine.

Les tranchées 37 peuvent, par exemple, être réalisées par sciage, en utilisant une lame de découpe de largeur inférieure ou égale (égale dans l'exemple représenté) à celle utilisée pour la réalisation des tranchées 31. Les tranchées 37 peuvent en variante être réalisées par ablation laser. Les tranchées 31, les tranchées 35 et les tranchées 37 sont par exemple alignées selon un même axe central.

A l'issue de l'étape illustrée en figure 12, la structure correspond à une pluralité de puces électroniques individuelles, reliées uniquement par le film support (non représenté en figure 12), chacune des puces individuelles comprenant un unique circuit intégré 13. Les puces peuvent ensuite être prélevées sur ce film support, en vue de leur montage dans un dispositif extérieur.

A l'issue du procédé décrit en relation avec les figures 7 à 12, on obtient des puces élémentaires dans lesquelles uniquement la face arrière et une partie inférieure des flancs du substrat 11 sont revêtus par une résine de protection 33. En particulier, une partie supérieure des flancs du substrat 11 reste libre, c'est-à-dire non revêtue par une résine de protection électriquement isolante.

Là encore, un avantage du procédé décrit est qu'il permet d'obtenir une structure intermédiaire dans laquelle les circuits intégrés 13 sont isolés électriquement mais solidaires mécaniquement des circuits intégrés 13 voisins (figure 10). Le test électrique final des puces peut avantageusement être réalisé sur cette structure intermédiaire, avant l'étape d'individualisation des puces.

Un avantage des modes de réalisation et des modes de mise en oeuvre décrits est qu'ils sont compatibles avec les procédés usuels de fabrication des puces électroniques.

Un autre avantage des modes de réalisation et des modes de mise en oeuvre décrits est qu'ils permettent de tester électriquement chacune des puces au cours de leur procédé de fabrication.

Un autre avantage des modes de réalisation et des modes de mise en oeuvre décrits est qu'ils permettent un bon maintien des puces lorsqu'elles sont testées électriquement.

Un autre avantage des modes de réalisation et des modes de mise en oeuvre décrits est qu'ils sont compatibles avec les appareils de tests usuels.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisations décrits ne se limitent pas aux exemples de dimensions et de matériaux mentionnés ci-dessus.

On notera que les modes de réalisation décrits sont tout particulièrement adaptés aux puces de petites dimensions, par exemple, présentant, en vue de dessus, une surface inférieure à 1 mm², de préférence inférieure à 0,3 mm². Les modes de réalisation décrits sont en particulier adaptés aux puces dans lesquelles les plots de reprise de contact 17 sont alignés sur une seule ligne, de préférence aux puces de forme parallélépipédique rectangle présentant uniquement deux plots de contact 17 sur une même face de connexion. Toutefois, les modes de réalisation décrits ne se limitent pas à ces cas particuliers.

Enfin, la mise en oeuvre pratique des modes de réalisation et variantes décrits est à la portée de la personne du métier à partir des indications fonctionnelles données ci-dessus.

## Revendications

1. Procédé de fabrication de puces électroniques comprenant :
a) le dépôt d'une couche de résine (19 ; 33) électriquement isolante du côté d'une première face d'un substrat semiconducteur (11), dans et sur lequel ont été préalablement formés une pluralité de circuits intégrés (13), le substrat semiconducteur portant sur une deuxième face, opposée à la première face, des plots de reprise de contact (17) ; et
b) la formation, du côté de la deuxième face du substrat semiconducteur (11), de premières tranchées (21 ; 35), séparant électriquement les circuits intégrés (13) les uns des autres, les premières tranchées s'étendant verticalement dans le substrat semiconducteur et débouchant dans ou sur la couche de résine (19 ; 33).

2. Procédé selon la revendication 1, dans lequel l'étape b) est suivie par une étape c) d'individualisation des puces électroniques.

3. Procédé selon la revendication 2, dans lequel l'individualisation de l'étape c) est réalisée par la formation de deuxièmes tranchées (25 ; 37) dans les premières tranchées (21 ; 35).

4. Procédé selon la revendication 2, dans lequel l'individualisation de l'étape c) est réalisée par l'amincissement de la couche de résine isolante (19).

5. Procédé selon l'une quelconque des revendications 2 à 4, comprenant, entre les étapes b) et c), une étape d) de test électrique des circuits intégrés (13).

6. Procédé selon l'une quelconque des revendications 1 à 5, dans lequel les premières tranchées (21) s'étendent dans toute l'épaisseur du substrat (11).

7. Procédé selon l'une quelconque des revendications 1 à 6, comprenant, entre l'étape a) et l'étape b), une étape de formation de troisièmes tranchées (31) s'étendant entre les circuits intégrés (13), depuis la première face du substrat semiconducteur (11), sur une partie de l'épaisseur du substrat semiconducteur.

8. Procédé selon la revendication 7, dans lequel les troisièmes tranchées (31) s'étendent dans le substrat semiconducteur (11) sur une profondeur (H1) comprise entre 30 % et 75 % de l'épaisseur du substrat semiconducteur.

9. Procédé selon la revendication 7 ou 8, dans lequel les troisièmes tranchées (31) ont une largeur (L3) supérieure à la largeur (L5) des premières tranchées (37).

10. Procédé selon l'une quelconque des revendications 1 à 9, dans lequel lors de l'étape a), l'épaisseur du substrat semiconducteur (11) est comprise entre 50 µm et 500 µm, de préférence entre 50 µm et 130 µm.
